# EUROPÄISCHE PATENTSCHRIFT

(11) **EP 3 513 179 B1**
(45) Veröffentlichungstag und Bekanntmachung des Hinweises auf die Patenterteilung: **17.06.2020**
(21) Anmeldenummer: 17840475.2
(22) Anmeldetag: 08.09.2017
(51) Int. Cl.: G01N 25/56, G01M 3/16, H01L 23/26

(54) **MIKROSYSTEMTECHNISCHE VORRICHTUNG MIT INTEGRIERTER TROCKENMITTELÜBERWACHUNG**
MICROSYSTEM DEVICE COMPRISING INTEGRATED DESICCANT MONITORING
DISPOSITIF À MICROSYSTÈME AVEC SURVEILLANCE INTÉGRÉE D'AGENT SICCATIF

(30) Priorität: 13.09.2016 DE 102016011046
(43) Veröffentlichungstag der Anmeldung: 24.07.2019
(73) Patentinhaber: Albert-Ludwigs-Universität Freiburg, 79098 Freiburg (DE)
(72) Erfinder: RUDMANN, Linda, 79098 Freiburg (DE); LANGENMAIR, Michael, 79108 Freiburg (DE); ORDONEZ, Juan Sebastian, 9000 Gent (BE); STIEGLITZ, Thomas, 79110 Freiburg (DE)
(74) Vertreter: Rösler, Uwe
(86) Internationale Anmeldenummer: PCT/EP2017/001066
(87) Internationale Veröffentlichungsnummer: WO 2018/050275

(56) Entgegenhaltungen:
- JP-A- 2004 008 968
- US-A- 5 968 386
- US-A1- 2006 067 645
- US-A1- 2012 235 970
- US-A1- 2016 161 431

## Beschreibung

### Technisches Gebiet

Die Erfindung betrifft eine miniaturisierte, mikrosystemtechnische Vorrichtung mit elektrischen und/oder optischen und/oder mechanischen Bauteilen in einem gegen Luftfeuchte nicht hermetisch oder hermetisch abgeschlossenen Gehäuse oder in einer gegen Luftfeuchte nicht-hermetischen Verkapselung, bei dem das Gehäuse oder die Verkapselung ein Trockenmittel enthält. Die Erfindung betrifft ferner ein Verfahren zur Bestimmung einer feuchteabhängigen Lebensdauer einer derartigen Vorrichtung.

### Stand der Technik

Sensoren, Aktoren und andere elektronische Vorrichtungen, die mit ihrer Umgebung interagieren, enthalten meist unterschiedlichste elektrische und/oder optische und/oder mechanische Bauteile. Diese Bauteile und/oder die elektrischen und/oder optischen Verbindungen zwischen ihnen reagieren meist sensibel auf den Wasserdampfgehalt ihrer Umgebung. Wasserdampf kann solche Vorrichtungen und deren Bauteile wie beispielsweise elektronische Schaltkreise, lichtemittierende Bauteile oder mechanische Schwingsysteme beeinflussen, irreversibel zerstören oder dies indirekt auslösen.
Es zeigt sich in vielen Fällen, dass die Umgebungsfeuchtigkeit der sensiblen Bauteile ausschlaggebend für die erwartete Lebensdauer der gesamten Vorrichtung ist. Für einen möglichst langen, zuverlässigen Betrieb von feuchtesensiblen Vorrichtungen in einer möglichst trockenen Atmosphäre werden deshalb folgende Anforderungen an deren Einhausung gestellt: Die anfälligen Bauteile müssen in ein Gehäuse verpackt werden, welches möglichst undurchlässig gegenüber von außen eindringendem Wasserdampf ist (hermetische oder nicht hermetische Verpackung/Verkapselung/Versiegelung). Zusätzlich muss eine Kondensation von Wasser im Gehäuseinneren vermieden werden. Letzteres gilt auch für eventuell im Gehäuse befindliche Wasserrückstände, obwohl dieses Gehäuse bereits bei Verschluss möglichst frei von physikalisch oder chemisch gebundenem Wasser sein muss. Da diese beiden Kriterien in der Realität nicht zu 100% eingehalten werden können, werden in vielen Produkten, welche ein hermetisches Gehäuse einsetzen, zusätzlich zu den funktionsrelevanten Bauteilen aktivierte Trockenmittel in das abgeschlossene Gehäuse eingebracht [1,2].
Um die feuchteinduzierte Lebensdauer von elektrischen, optischen oder mechanischen Bauteilen zu quantifizieren ist es üblich, die Zeitspanne anzugeben, bis zu welcher eine Volumenkonzentration von 0,5 % Wasserdampf in einem hermetisch oder auch nicht hermetisch abgeschlossenen Gehäusevolumen erreicht wird (kritische Wasserdampfkonzentration). Diese Lebensdauer wird meist durch die Bestimmung der Leckrate von Wasserdampf pro Zeiteinheit in das Gehäuse berechnet [3]. Neue Produkte und Produktfelder beispielsweise in der Medizintechnik, der Automobilindustrie oder der Unterhaltungselektronik setzen immer kleiner werdende hermetisch abgeschlossene Gehäuse ein. Bei diesen neuen, kleineren Gehäusevolumina treten im Vergleich zu klassischen, größeren Lösungen nun neue Herausforderungen bei der Bestimmung der feuchtigkeitsabhängigen Lebensdauer der miniaturisierten, mikrosystemtechnischen Vorrichtungen auf. Beispielsweise können die maximal erlaubten Leckraten von Wasserdampf pro Zeiteinheit in das Gehäuse nicht mehr durch vorhandene Methoden und Geräte aufgelöst werden. Auch eine direkte Messung der Luftfeuchte im miniaturisierten Gehäuse ist teilweise nicht möglich, da Sensoren, die über die benötigte Genauigkeit verfügen, zu groß sind. Indirekte, kumulative Messungen der Wasserdampfleckrate in derartigen, hermetisch oder nicht hermetisch abgeschlossenen Vorrichtungen ermöglichen höhere Sensitivitäten, können aber aufgrund der langen Testzeiten nicht für wirtschaftliche Produktionsprozesse in Betracht gezogen werden.
Die klassische Herangehensweise zur Sicherstellung einer feuchtigkeitsabhängigen Lebensdauer der Vorrichtungen von mindestens 50 Jahren mit Hilfe der Wasserdampfleckrate in das hermetisch oder nicht hermetisch abgeschlossene Gehäuse kann nur bis zu einem minimalen Innenvolumen des Gehäuses von 10 mm³ robust durchgeführt werden. Beispiel: Um die Testmethode TM 1014.14 in [4] über einen Zeitraum von mehr als 30 Jahren zu erfüllen, muss die Leckrate von Wasserdampf in ein 0,125 mm³ kleines Gehäuse < 10⁻¹⁴ cm³/s sein. Gängiges Equipment kann allerdings nur einen Messbereich bis minimal 10⁻¹³ cm³/s auflösen [5].
Des Weiteren ist die direkte Messung der Luftfeuchte in miniaturisierten, hermetisch oder nicht hermetisch abgeschlossenen Gehäusen (internes Volumen < 1 mm³) aus Platzgründen und der nicht gegebenen Verfügbarkeit kommerzieller Sensoren mit ausreichender Genauigkeit nicht möglich. Einer der wenigen miniaturisierten Sensoren mit ausreichender Genauigkeit bei Luftfeuchten < 10 rH%, der Sensirion SHT31, hat beispielsweise ein Volumen von 5,625 mm³ [6]. Wird außerdem ein Trockenmittel eingesetzt, welches die Luftfeuchte im hermetisch oder nicht hermetisch abgeschlossenen Gehäuse niedrig hält, ändert sich die interne Luftfeuchte bis zur Sättigung des Trockenmittels kaum und kann deshalb schwer durch einen Luftfeuchtesensor beobachtet werden, wie in [7, 8] zu sehen.
Ist die Absorptionsrate eines Trockenmittels wenig abhängig vom aktuellen Grad der Absorption im Trockenmittel, kann zu keinem Zeitpunkt auf die verbleibende Absorptionskapazität des Trockenmittels rückgeschlossen werden. Beispiel: Kommt Zeolith als Trockenmittel in einem hermetisch oder nicht hermetisch abgeschlossenen Gehäuse zum Einsatz, kann mit bisherigen Methoden zur Überwachung der Feuchtebedingungen im Implantat (wie Messung der Raumluftfeuchte) nicht auf den Absorptionsgrad des Trockenmittels rückgeschlossen werden.
Auch ist die direkte Messung der Luftfeuchte im hermetisch oder nicht hermetisch abgeschlossenen Gehäuse nicht möglich, wenn es gewünscht ist, das komplette freie Innenvolumen des Gehäuses mit Trockenmittel zu füllen.
Bisher angewandte und zugelassene Messmethoden zur Abschätzung der feuchteabhängigen Lebensdauer von Vorrichtungen in hermetischen oder nicht hermetisch abgeschlossenen Gehäusen können nur bis zu einem minimalen Gehäusevolumen angewandt werden. Die Bestimmung der feuchteabhängigen Lebensdauer von Vorrichtungen in kleineren hermetisch abgeschlossenen Gehäusen benötigt neue Messmethoden [10]. Vor allem für Vorrichtungen welche nicht hermetisch verkapselt, d.h. ohne freien Hohlraum abgeschlossen sind, eignen sich bisher verfügbare Methoden zur Bestimmung der feuchteabhängigen Lebensdauer nur bedingt. Da diese Gehäuse kein freies inneres Gehäusevolumen aufweisen, ist es zum Beispiel nicht möglich, die Testmethode TM 1014.14 anzuwenden. Bei nicht hermetisch verkapselten Vorrichtungen werden die Bauteile zum Beispiel in Polymeren oder Epoxiden vollkommen eingegossen, so dass kein freies inneres Gehäusevolumen mehr zur Verfügung steht.

Aus US 2006/0067645 A1 sind verschiedene Verfahren zur Bestimmung der Feuchtigkeit in einem versiegelten Gehäuse einer MEMS-Vorrichtung offenbart. Die Verfahren umfassen Wiegen der gesamten Anordnung vor und nach der Exposition in einer feuchten Testumgebung, Erfassung eines Farbumschlags des Trockenmittels durch ein Fenster im Gehäusedeckel, Bestimmen der Luftfeuchte mithilfe eines externen resistiven Feuchtigkeitssensor oder Erfassung einer Frostbildung im Gehäuse (optisch oder mittels externem Feuchtigkeitssensor) bei Anlegen eines Kältefingers an das Gehäuseäußere.

Aus US 2012/235970 A1 ist der Einsatz von Zeolithen oder Kieselgel als Trockenmittel in einer MEMS-Vorrichtung bekannt.

In US 2016/161431 A1 wird eine Trockenmittelkartusche mit kammartig ineinandergreifenden Leiterstrukturen offenbart, die jeweils mit Elektroden verbunden sind. Durch Bestimmung des Widerstands bzw. der Widerstandsänderungsrate zwischen den Elektroden und Vergleich mit einem vorgegebenen Schwellwert kann eine Sättigung des Trockenmittels und ein erforderlicher Austausch der Kartusche bzw. ein Defekt einer Versieglung eines Gehäuses, in das die Kartusche eingeschraubt wird, festgestellt werden.

### Beschreibung der Erfindung

Die Erfindung hat zur Aufgabe, die Lebensdauer von miniaturisierten, mikrosystemtechnischen Vorrichtungen bestehend aus elektrischen und/oder optischen und/oder mechanischen Bauteilen in Abhängigkeit von der Umgebungsfeuchte in einem hermetisch oder nicht hermetisch abgeschlossenen Gehäuse oder nicht hermetisch verkapselten Vorrichtungen zu bestimmen.

Diese Aufgabe wird erfindungsgemäß gelöst durch eine miniaturisierte, mikrosystemtechnische Vorrichtung nach Anspruch 1 sowie durch ein Verfahren nach Anspruch 4. In vielen miniaturisierten, mikrosystemtechnischen Vorrichtungen in hermetisch abgeschlossenen Gehäusen ist der Einsatz eines Trockenmittels vorgesehen. Dieses Trockenmittel kann eintretende Feuchtigkeit physikalisch oder chemisch binden und somit die feuchtebestimmte Lebensdauer der sich im hermetischen Gehäuse befindlichen Bauteile signifikant erhöhen [9]. Beispiele für physikalische Trockenmittel sind Zeolithe oder Kieselgel. Zeolith kann beispielsweise Wasserdampf bis über 20% der Zeolithmasse absorbieren.

Der Absorptionsgrad von vielen Trockenmitteln ist abhängig von der das Trockenmittel umgebenen Raumluftfeuchte. Durch die Messung des Absorptionsgrades des Trockenmittels kann also auf die Raumluftfeuchte rückgeschlossen werden. Dadurch kann ein Überschreiten der kritischen Wasserdampfkonzentration gemessen und/oder extrapoliert werden, was der Bestimmung der Lebensdauer der elektrischen, optischen oder mechanischen Bauteile entspricht.

Die erfinderische Lösung zur Bestimmung der Lebensdauer der hermetisch oder nicht hermetisch eingehausten miniaturisierten Vorrichtung hat das Potential einer stärkeren Miniaturisierung und Systemintegration als es zum Beispiel bisherige kommerzielle Luftfeuchtesensoren ermöglichen. Es ist beispielsweise möglich, die Absorption des Trockenmittels mit einem eingebauten mikrosystemtechnisch hergestellten planaren Sensorsystem zu bestimmen. Durch diese direkte Kombination eines stark miniaturisierten Sensorsystems und eines Trockenmittels können Synergieeffekte und Platzersparnisse erreicht werden, die unter Einsatz bisheriger kommerzieller Sensoren zur Raumluftfeuchte nicht möglich sind.

Durch den Einsatz von Trockenmitteln, welche durch ihre Absorptionscharakteristik die Raumluftfeuchte im hermetisch oder nicht hermetisch abgeschlossenen Gehäuse bis zu ihrer Sättigung konstant relativ niedrig halten, kann der stetig steigende Absorptionsgrad des Trockenmittels gemessen und aufgezeichnet werden. Beispielsweise kann damit eine Sättigung des Trockenmittels vorausbestimmt werden, bevor es aufgrund der Sättigung des Trockenmittels zu einer signifikanten Erhöhung der Luftfeuchte im freien hermetisch oder nicht hermetisch eingehausten Innenvolumen kommen kann. Bei nicht hermetischen Verkapselungen ist durch den Einsatz eines solchen Systems erstmals eine kontinuierliche Bestimmung des, durch die Verkapselung eindringenden, Wassergehaltes möglich.

Viele bisher eingesetzte Sensoren zur Messung der Raumluftfeuchte verwenden ebenfalls ein Material, dessen Wassergehalt abhängig von der umgebenen Raumluftfeuchte ist. Beispielsweise misst der kapazitive Feuchtigkeitssensor Sensirion SHT31 die Wasserabsorption einer eingebauten Polymermembran [6]. Die geringe Wasserabsorption der dünnen Polymermembran beeinflusst die Feuchtebedingungen im hermetisch oder nicht hermetisch abgeschlossenen Gehäusevolumen kaum. Bei der hier vorgestellten Erfindung wird erstmals der raumluftfeuchteabhängige Wassergehalt eines Materials ermittelt, dessen Wasserabsorption zur Funktionalität (Lebensdauererhöhung) des restlichen hermetischen oder nicht hermetischen Systems beiträgt.

Durch die Ermittlung der Wasserabsorption des Trockenmittels ist die Lebensdauerkontrolle im hermetisch oder nicht hermetisch abgeschlossenen Gehäuse bis zu einem gewissen Grad entkoppelt von den Feuchtebedingungen im verbleibenden Gehäusevolumen: beispielsweise kann Zeolith die Luftfeuchte im hermetisch oder nicht hermetisch abgeschlossenen Gehäusevolumen konstant niedrig halten. In der hier vorgestellten Vorrichtung (hermetisch oder nicht hermetisch eingehaust) kann somit der (lineare) Anstieg der physikalisch gebundenen Wassermenge im Trockenmittel untersucht werden, wobei der Feuchtegehalt im verbleibenden Gehäuseinnenvolumen konstant niedrig bleibt. Bei nicht hermetisch verkapselten Vorrichtungen (d.h. es ist kein inneres freies Gehäusevolumen vorhanden) wird so erstmalig Kenntnis über den tatsächlich durch die Verkapselung stattfindenden Wassereintritt ermöglicht.

Erstmals ist durch die Erfindung das freie Volumen des hermetisch oder nicht hermetisch abgeschlossenen Gehäuses nicht ausschlaggebend für die Messbarkeit des Wassereintritts in das abgeschlossene Gehäuse. Das Volumen im hermetischen oder nicht hermetischen Gehäuse, welches nicht von den relevanten Bauteilen der eingehausten Vorrichtung eingenommen wird, kann komplett mit Trockenmittel verfüllt werden, wenn angenommen werden kann, dass sich das gebundene Wasser im Trockenmittel gleichmäßig verteilen kann. Dies kann beispielsweise durch die Verwendung von Zeolith als Trockenmittel möglich gemacht werden, da die Feuchte sich bis zu einem gewissen Grad im Material verteilen kann [11].

Die Erfindung macht es auch möglich, die Sättigung eines in einer hermetisch oder nicht hermetisch abgeschlossenen Vorrichtung lokalisierten Trockenmittels zu detektieren. Ist die maximale Absorptionskapazität des Trockenmittels bekannt, kann durch die Überwachung des Absorptionsgrades des Trockenmittels der Grad der Sättigung desselbigen überwacht werden. Durch den punktuellen Absolutwert des Absorptionsgrades und/oder der Auswertung des zeitlichen Verlaufs des Absorptionsgrades des Trockenmittels kann ein eventuelles Ende der Wasserabsorptionsfähigkeit des Trockenmittels voraus berechnet werden. Dadurch kann ein Ende der Lebensdauer (Ende der Lebensdauer definiert als Volumenanteil von Wasserdampf > 0,5 %) der abgeschlossenen Vorrichtung kalkuliert und/oder bestimmt, bzw. ermittelt werden, bzw. die Höhe des durch die Verkapselung gedrungenen Wassergehalts eines nicht hermetisch verkapselten Systems bestimmt werden.

Es kann die feuchteabhängige Lebensdauer der erfinderischen, miniaturisierten hermetisch oder nicht hermetisch abgeschlossenen Vorrichtung für elektrische und/oder optische und/oder mechanische Bauteile bestimmt werden, die nicht mehr mit klassischem etablierten Messsystemen aufgelöst werden kann.

Die Messung der Absorption des Trockenmittels ist eine genauere, integrierende Messung der Absorption des Trockenmittels als eine punktuelle Bestimmung der Wasserdampfleckrate in das System.

Durch die Verwendung des Trockenmittels als Messsubstrat und als Wasserabsorber ergeben sich vorteilhafte Synergieeffekte und es werden sonst nicht erreichbare Platzersparnisse ermöglicht. Wird die Wasserabsorption des Trockenmittels, das gleichzeitig die Lebensdauer der hermetisch oder nicht hermetisch eingehausten Vorrichtung deutlich erhöht, gemessen, wird kein zusätzlicher Sensor zur Beobachtung der Luftfeuchte des freien eingehausten Volumens benötigt. Somit wird auch kein freies Volumen im miniaturisierten hermetischen Gehäuse benötigt.

Durch die Detektion und/oder Vorausbestimmung der tatsächlichen oder zukünftigen (baldigen) Sättigung des Trockenmittels kann ein Ende der Lebensdauer der hermetisch oder nicht hermetisch eingehausten Vorrichtung bestimmt und/oder abgeschätzt werden. Eine Abschätzung der zukünftigen (baldigen) Sättigung des Trockenmittels ist somit ebenfalls bei nicht hermetisch verkapselten Systemen möglich.

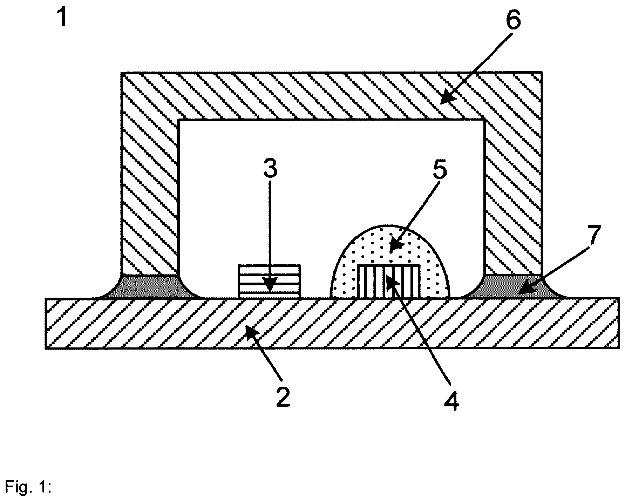

Die Erfindung wird nachstehend ohne Beschränkung des allgemeinen Erfindungsgedankens anhand der Fig. 1 exemplarisch für ein hermetisches oder nicht hermetisches Gehäuses mit freiem inneren Gehäusevolumen dargestellt. Eine Ausführung für nicht hermetisch verkapselte Vorrichtungen würde derart aussehen, dass kein freies inneres Volumen vorhanden ist. Das heißt, ein nicht hermetisches Material (z.B. Polymer oder Epoxid) wird direkt auf die elektrischen, optischen oder mechanischen Bauteile sowie auf das Trockenmittelsystem aufgebracht.

### Bezugszeichenliste:

- 1: Miniaturisierte, mikrosystemtechnische Vorrichtung
- 2: Gehäuseboden
- 3: Elektrische, optische oder mechanische Bauteile
- 4: Messwertumformer
- 5: Trockenmittel
- 6: Gehäusedeckel
- 7: Versiegelung

Die miniaturisierte, mikrosystemtechnische Anordnung (1) ist auf einem gegen Luftfeuchte hermetischen oder nicht hermetischen Gehäuseboden (2) angeordnet. Es können sich elektrische oder sonstige Verbindungen zwischen dem hermetisch oder nicht hermetisch abgeschlossenen Gehäuseinnenvolumen und einem äußerem System im Gehäuseboden (2) oder zwischen Gehäuseboden (2) und dem Gehäusedeckel (6) befinden. Der Gehäuseboden (2) kann auch Teil von (6) sein. In der Vorrichtung (1) sind elektrische und/oder optische und/oder mechanische feuchteempfindliche Bauteile (3) vorhanden. Der unter (4) beschriebene Messwertumformer kann elektrisch, optisch oder mechanisch mit den Bauteilen (3) gekoppelt sein oder ein Teil derer sein. Der Messwertumformer (4) wandelt die Absorption des Trockenmittels (5) in ein elektrisches Signal um. Erfindungsgemäß erfolgt dies durch Impedanzspektroskopie bei sich ändernder Messfrequenz (Δf) wobei z.B. eine sich ändernde Messsignalamplitude (ΔAC) und/oder ein sich ändernder durchschnittlicher Messsignalwert (ΔDC) aufgezeichnet werden. Die Sensorantwort kann dabei telemetrisch, optisch oder elektrisch ausgelesen und/oder aufgezeichnet werden.

Zum Beispiel kann eine Struktur entwickelt werden, die über die Realisierung von kammartigen Kondensatorstrukturen die Impedanz des auf diesen Kondensatorstrukturen lokalisierten Trockenmittels ausliest.

Als Trockenmittel (5) kann zum Beispiel ein physikalisches Trockenmittel verwendet werden. Es kann Kieselgel verwendet werden, das eine der höchsten Wasserabsorptionskapazitäten von bekannten physikalischen Trockenmitteln aufweist. Es kann Zeolith verwendet werden, um die Feuchtigkeit möglichst lange auf einem möglichst geringen Wert zu halten. Die Trockenmittel können sich in einem Bindemittelsystem (zum Beispiel Polymer) befinden. Die Wasserabsorption des Trockenmittels bzw. des Trockenmittel-Binder-Systems kann durch (4) gemessen werden. Es kann durch die Überwachung des Trockenmittels auf die Luftfeuchte im hermetischen oder nicht hermetischen abgeschlossenen Gehäuse und/oder auf den Sättigungsgrad des Trockenmittels bzw. des Trockenmittel-Binder-Systems rückgeschlossen werden. Somit können Aussagen zur erwarteten, tatsächlichen und zukünftigen feuchtebestimmten Lebensdauer der eingehausten Vorrichtung und deren Bauteile getroffen werden. Das Trockenmittel wird im abgeschlossenen Gehäusevolumen lokalisiert. Dabei kann es das Gehäuseinnenvolumen teilweise oder komplett ausfüllen. (6) stellt den Gehäusedeckel dar. Er kann aus demselben Material wie (2) oder einem von (2) verschiedenen Material hergestellt sein. (6) kann ebenfalls aus einem nicht hermetischen Material bestehen. So kann (6) zum Beispiel ein komplett umschließendes nicht hermetisches Material (z.B. ein Polymer) sein. Es können sich gegen Luftfeuchte hermetische und/oder nicht hermetische, elektrische und/oder sonstige Verbindungen zwischen dem Gehäuseinnenvolumen und einem äußerem System im Gehäuse befinden. (7) ist die Versiegelung der Verpackung. (7) kann ebenfalls aus einem hermetischen oder nicht hermetischen Material bestehen.

### Referenzen

[1] M. Moraja, M. Amiotti, "Advanced getter solutions at wafer level to assure high reliability to the last generations MEMS" 41st Annual Int'l Reliability Physics Symposium, pp. 458-459, 2003.
[2] G. E. Loeb, R. A. Peck, W. H. Hoore, K. Hood, "BIONTM system for distributed neural prosthetic interfaces," Medical Engineering & Physics, vol. 23, pp. 9-18, 2001.
[3] H. Greenhouse, "Hermeticity of electronic packages," Noyes Publications, Park Ridge, New Jersey, USA; William Andrew Publishing, LLC, Norwich, New York, USA, 2000.
[4] United States of America Department of Defense 2015 TEST METHOD STANDARD Microcircuits, MIL-STD-883J. Available at http://www.dscc.dla.miVDownloads/MilSpec/Docs/MIL-STD-883/std883.pdf.
[5] VIC Leak Detection MS-50 Datasheet
[6] Sensirion AG *Datasheet SHT3x- DIS.*
[7] N. Dahan, N. Donaldson, S. Taylor, N. Sereno, "The application of PEEK to the Packaging of Implantable Electronic Devices: Water Permeation Calculation Methos and Maximum Achievable Lifetime with Desiccant," Journal of Microelectronics and Electronic Packaging, vol. 10, pp. 15-22, 2013
[8] M. Schuettler, A. Schatz, J. S. Ordonez, T. Stieglitz, "Ensuring Minimal Humidity Levels in Hermetic Implant Housings," 33rd Annual Int'l Conference of the IEEE EMBS, pp. 2296-2299, 2011*.*
[9] M. Schuettler, T. Stieglitz, "Microassembly and micropackaging of implantable systems,"Woodhead Publishing Series in Biomaterials, No. 52, pp. 108-149, 2013.
[10] R. C. Kullberg, A. Jonath, R. K. Lowry, The Unsettled World of Leak Rate Physics: 1 Atm Large - Volume Considerations do Not Apply to MEMS Packages, A Practitioner's Perspective," in Proc. of SPIE, vol. 8250, 82500H, 2012.
[11] M. Salimian et. al, "electrical conductivity of LTA-zeolite in the presence of poly(vinyl alcohol) and poly(vinyl pyrrolidone) polymers," Polym Int (Wiley Online Library), vol. 62, pp. 1583-1588, 2013.

## Patentansprüche

1. Miniaturisierte, mikrosystemtechnische Vorrichtung (1) mit elektrischen und/oder optischen und/oder mechanischen Bauteilen (3) in einem gegen Luftfeuchte nicht hermetisch oder hermetisch abgeschlossenen Gehäuse oder in einer gegen Luftfeuchte nicht-hermetischen Verkapselung, bei dem das Gehäuse oder die Verkapselung ein Trockenmittel (5) enthält,
**dadurch gekennzeichnet, dass** im Gehäuse oder in der Verkapselung zur Messung eines Absorptionsgrades des Trockenmittels (5) ein Messwertumformer (4) vorgesehen ist, der zur Umwandlung einer Wasserabsorption des Trockenmittels (5) in ein elektrisches Signal mittels Impedanzspektroskopie ausgebildet ist.

2. Vorrichtung nach Anspruch 1,
**dadurch gekennzeichnet, dass** der Messwertumformer (4) kammartige Kondensatorstrukturen aufweist, und dass das Trockenmittel (5) auf den kammartigen Kondensatorstrukturen lokalisiert ist.

3. Vorrichtung nach Anspruch 1 oder 2,
**dadurch gekennzeichnet, dass** als Trockenmittel (5) Zeolithe oder Kieselgele vorgesehen sind.

4. Verfahren zur Bestimmung einer feuchteabhängigen Lebensdauer einer miniaturisierten, mikrosystemtechnischen Vorrichtung (1) mit elektrischen und/oder optischen und/oder mechanischen Bauteilen (3) in einem gegen Luftfeuchte nicht hermetisch oder hermetisch abgeschlossenen Gehäuse oder in einer gegen Luftfeuchte nicht-hermetischen Verkapselung,
bei dem ein Absorptionsgrad eines in dem Gehäuse oder in der Verkapselung enthaltenen Trockenmittels (5) mittels eines im Gehäuse oder in der Verkapselung vorgesehenen Messwertumformers (4) gemessen wird, der eine Wasserabsorption des Trockenmittels (5) mittels Impedanzspektroskopie in ein elektrisches Signal wandelt, und
bei dem durch Detektion und/oder Vorausbestimmung einer Sättigung des Trockenmittels (5) die feuchteabhängige Lebensdauer der Vorrichtung (1) bestimmt und/oder abgeschätzt wird.

5. Verfahren nach Anspruch 4,
**dadurch gekennzeichnet, dass** ein Ende der Wasserabsorptionsfähigkeit des Trockenmittels (5) aus einem punktuellen Absolutwert und/oder durch Auswertung eines zeitlichen Verlaufs des Absorptionsgrades des Trockenmittels (5) vorausberechnet wird.

6. Verfahren nach Anspruch 5, **dadurch gekennzeichnet, dass** ein Ende der Lebensdauer der abgeschlossenen Vorrichtung (1) bestimmt wird, wobei das Ende der Lebensdauer durch einen Volumenanteil von Wasserdampf > 0,5% im abgeschlossenen Gehäuse definiert ist.

7. Verfahren nach Anspruch 4 **dadurch gekennzeichnet, dass** ein stetiges Ansteigen des Absorptionsgrades des Trockenmittels (5) in der Verkapselung gemessen und aufgezeichnet wird, und dass hieraus ein Wassergehalt in der Verkapselung bestimmt wird.

8. Verfahren nach einem der Ansprüche 4 bis 7,
**dadurch gekennzeichnet, dass** die Umwandlung der Wasserabsorption des Trockenmittels (5) in das elektrische Signal mittels Impedanzspektroskopie bei sich ändernder Messamplitude und/oder durchschnittlichem Messsignalwert geschieht.

9. Verfahren nach einem der Ansprüche 4 bis 8,
**dadurch gekennzeichnet, dass** eine Sensorantwort telemetrisch, optisch oder elektrisch ausgelesen und/oder aufgezeichnet wird.

## Claims

1. Miniaturised, microsystem device (1) with electrical, and/or optical, and/or mechanical, components (3), in a housing that is not hermetic, or not hermetically sealed, against air humidity, or in an encapsulation that is not hermetic against air humidity, in which the housing or the encapsulation contains a desiccant (5),
**characterised in that**,
a measurement transducer (4) is provided in the housing, or in the encapsulation, for the measurement of a degree of absorption of the desiccant (5), which measurement transducer is designed for the conversion of water absorption of the desiccant (5) into an electrical signal by means of impedance spectroscopy.

2. Device according to Claim 1,
**characterised in that**,
the measurement transducer (4) has comb-like capacitor structures,
and **in that**,
the desiccant (5) is located on the comb-like capacitor structures.

3. Device according to Claim 1 or 2,
**characterised in that**,
zeolites or silica gels are provided as desiccants (5) .

4. Method for determining a moisture-dependent service life of a miniaturised microsystem device (1) with electrical, and/or optical, and/or mechanical, components (3) in a housing that is not hermetic, or not hermetically sealed, against air humidity, or in an encapsulation that is not hermetic against air humidity,
in which,
a degree of absorption of a desiccant (5) contained in the housing or in the encapsulation is measured by means of a measurement transducer (4) provided in the housing, or in the encapsulation, which measurement transducer converts a water absorption of the desiccant (5) into an electrical signal by means of impedance spectroscopy,
and in which,
by detection, and/or predetermination, of a saturation of the desiccant (5), the moisture-dependent service life of the device (1) is determined, and/or estimated.

5. Method according to Claim 4,
**characterised in that**,
an end point of the water absorption capacity of the desiccant (5) is predicted from a selective absolute value, and/or by evaluation of a time-wise profile of the degree of absorption of the desiccant (5).

6. Method according to Claim 5,
**characterised in that**,
an end point of the service life of the sealed device (1) is determined, wherein the end point of the service life is defined by a volume fraction of water vapour that is > 0.5 % in the sealed housing.

7. Method according to Claim 4,
**characterised in that**,
a steady increase in the degree of absorption of the desiccant (5) in the encapsulation is measured and recorded,
and **in that**,
water content in the encapsulation is determined therefrom.

8. Method according to one of the Claims 4 to 7,
**characterised in that**,
the conversion of the water absorption of the desiccant (5) into the electrical signal takes place by means of impedance spectroscopy, with a changing measurement amplitude, and/or an average measurement signal value.

9. Method according to one of the Claims 4 to 8,
**characterised in that**,
a sensor response is read, and/or recorded, telemetrically, optically or electrically.

## Revendications

1. Dispositif (1) miniaturisé, relevant de la microtechnique, pourvu de composants (3) électriques et/ou optiques et/ou mécaniques dans un boîtier fermé de manière non hermétique ou hermétique à l'humidité de l'air ou dans un encapsulage non hermétique à l'humidité de l'air, sur lequel le boîtier ou l'encapsulage contient un agent dessiccateur (5),
**caractérisé en ce que** dans le boîtier ou dans l'encapsulage est prévu pour mesurer un taux d'absorption par l'agent dessiccateur (5) un convertisseur de mesure (4) qui est conçu pour convertir au moyen d'une spectroscopie par impédance une absorption d'eau par l'agent dessiccateur (5) en un signal électrique.

2. Dispositif selon la revendication 1,
**caractérisé en ce que** le convertisseur de mesure (4) comporte des structures de condensateur en forme de peigne, et **en ce que** l'agent dessiccateur (5) est localisé sur les structures de condensateur en forme de peigne.

3. Dispositif selon la revendication 1 ou 2,
**caractérisé en ce que** de la zéolithe ou des gels de silice sont prévus en tant qu'agent dessiccateur (5).

4. Procédé, destiné à déterminer une durée de vie dépendant de l'humidité d'un dispositif (1) miniaturisé, relevant de la microtechnique, pourvu de composants (3) électriques et/ou optiques et/ou mécaniques dans un boîtier fermé de manière non hermétique ou hermétique à l'humidité de l'air ou dans un encapsulage non hermétique à l'humidité de l'air, lors duquel on mesure un taux d'absorption d'un agent dessiccateur (5) contenu dans le boîtier ou dans l'encapsulage au moyen d'un convertisseur de mesure (4) prévu dans le boîtier ou dans l'encapsulage, qui convertit au moyen de la spectroscopie par impédance une absorption d'eau par l'agent dessiccateur (5) en un signal électrique, et
lors duquel par détection et/ou par prédétermination d'une saturation de l'agent dessiccateur (5), on détermine et/ou on estime la durée de vie dépendant de l'humidité du dispositif (1).

5. Procédé selon la revendication 4,
**caractérisé en ce qu'**on calcule préalablement une fin de la capacité d'absorption d'eau de l'agent dessiccateur (5) à partir d'une valeur absolue ponctuelle et/ou par évaluation d'une courbe temporelle du taux d'absorption de l'agent dessiccateur (5).

6. Procédé selon la revendication 5,
**caractérisé en ce qu'**on détermine une fin de la durée de vie du dispositif (1) fermé, la fin de la durée de vie étant définie par une part en volume de vapeur d'eau > 0,5 % dans le boîtier fermé.

7. Procédé selon la revendication 4,
**caractérisé en ce qu'**on mesure et on enregistre une croissance constante du taux d'absorption de l'agent dessiccateur (5) dans l'encapsulage et **en ce qu'**on détermine à partir de là une teneur en eau dans l'encapsulage.

8. Procédé selon l'une quelconque des revendications 4 à 7,
**caractérisé en ce que** la conversion de l'absorption d'eau de l'agent dessiccateur (5) dans le signal électrique au moyen d'une spectroscopie par impédance s'effectue à une amplitude de mesure variable et/ou à une valeur moyenne du signal de mesure.

9. Procédé selon l'une quelconque des revendications 4 à 8,
**caractérisé en ce qu'**on lit et/ou on enregistre une réponse du capteur par voie télémétrique, optique ou électrique.
